# EUROPEAN PATENT SPECIFICATION

(11) **EP 3 235 587 B1**
(45) Date of publication and mention of the grant of the patent: **01.01.2020**
(21) Application number: 15869567.6
(22) Date of filing: 24.02.2015
(51) Int. Cl.: B23K 35/26, B23K 35/02, B23K 35/22, C22C 1/06, C22C 13/02, B23K 35/30

(54) **SOLDER ALLOY, SOLDER PASTE AND ELECTRONIC CIRCUIT BOARD**
LÖTLEGIERUNG, LÖTPASTE UND ELEKTRONISCHE LEITERPLATTE
ALLIAGE DE SOUDURE, PÂTE DE SOUDURE ET CARTE DE CIRCUITS IMPRIMÉS

(30) Priority: 15.12.2014 JP 2014253280
(43) Date of publication of application: 25.10.2017
(73) Proprietor: Harima Chemicals, Inc., Kakogawa-shi, Hyogo 675-0019 (JP)
(72) Inventor: IKEDA, Kazuki, Kakogawa-shi Hyogo 675-0019 (JP); INOUE, Kosuke, Kakogawa-shi Hyogo 675-0019 (JP); ICHIKAWA, Kazuya, Kakogawa-shi Hyogo 675-0019 (JP); TAKEMOTO, Tadashi, Tsukuba-shi Ibaraki 300-2635 (JP)
(74) Representative: SSM Sandmair
(86) International application number: PCT/JP2015/055203
(87) International publication number: WO 2016/098358

(56) References cited:
- EP-A1- 1 598 142
- WO-A1-2006/040582
- WO-A1-2012/056753
- WO-A1-2014/163167
- JP-A- H09 181 125
- JP-A- 2006 524 572
- JP-A- 2008 521 619
- JP-A- 2015 020 182
- US-B1- 6 224 690

## Description

Patent Document 1: WO2014/163167

### SUMMARY OF THE INVENTION

### PROBLEM TO BE SOLVED BY THE INVENTION

Meanwhile, soldering with such a solder alloy may cause damages on solder connection portion by shock such as dropping vibration. Therefore, improvement in shock resistance after soldering is required for the solder alloy.

Furthermore, a component soldered with a solder alloy may be used under relatively severe temperature cycle conditions (e.g., temperature cycle between -40 to 125°C etc.) such as an engine room of automobiles. Therefore, the solder alloy has been required to keep shock resistance even if it is exposed to relatively severe temperature cycle conditions.

The document US 6,224,690 B1 relates to an interconnection structure suitable for the connection of microelectronic circuit chips to packages. In particular, the invention pertains to the area-array or flip-chip technology often called C4 (controlled collapse chip connection). The structure comprises an adhesion/barrier layer deposited on a passivated substrate (e.g., a silicon wafer), optionally an additional adhesion layer, a solderable layer of a metal selected from the group consisting of Ni, Co, Fe, NiFe, NiCo, CoFe and NiCoFe on the adhesion/barrier layer, and a lead-free solder ball comprising tin as the predominate component and one or more alloying elements selected from Bi, Ag, and Sb, and further optionally including one or more elements selected from the group consisting of Zn, In, Ni, Co and Cu.

The document WO 2014/163,167 A1 relates to a lead-free solder alloy for an in-vehicle electronic circuit. With the increasing density of in-vehicle electronic circuits, not only conventional cracks at bonding interfaces such as between the substrate and the solder attachment site or a component and the solder attachment site, but also novel cracking problems of cracks occurring in the Sn matrix in the interior of the bonded solder have appeared. To solve the above problem, a lead-free solder alloy with 1 to 4 mass% Ag, 0.6 to 0.8 mass% Cu, 1 to 5 mass% Sb, 0.01 to 0.2 mass% Ni and the remainder being Sn is used. A solder alloy, which not only can withstand harsh temperature cycling characteristics from low temperatures of -40°C to high temperatures of 125°C but can also withstand external forces that occur when riding up on a curb or colliding with a vehicle in front for long periods, and an in-vehicle electronic circuit device using said solder alloy can thereby be obtained.

An object of the present invention is to provide a solder alloy having excellent shock resistance and which can keep excellent shock resistance even under exposure to relatively severe temperature cycle conditions, a solder paste containing the solder alloy, and an electronic circuit board produced by using the solder paste.

### MEANS FOR SOLVING THE PROBLEM

A solder alloy according to one aspect of the present invention is a solder alloy consisting of tin, silver, copper, bismuth, antimony, and cobalt, wherein relative to a total amount of the solder alloy, the silver content is 2 mass% or more and 4 mass% or less, the copper content is 0.3 mass% or more and 1 mass% or less, the bismuth content is more than 4.8 mass% and 10 mass% or less, the antimony content is 3 mass% or more and 10 mass% or less, the cobalt content is 0.001 mass% or more and 0.3 mass% or less, the tin content is the remaining proportion.

It is preferable that the solder alloy further contains at least one element selected from the group consisting of nickel, indium, gallium, germanium, and phosphorus, and relative to a total amount of the solder alloy, 1 mass% or less of the element is contained.

It is preferable that in the solder alloy, the copper content is 0.5 mass% or more and 0.7 mass% or less.

It is preferable that the bismuth content is more than 4.8 mass% and 7 mass% or less.

It is preferable that the antimony content is 5 mass% or more and 7 mass% or less.

It is preferable that the cobalt content is 0.003 mass% or more and 0.01 mass% or less.

A solder paste according to another aspect of the present invention contains a solder powder composed of the above-described solder alloy and flux.

An electronic circuit board according to further another aspect of the present invention includes a soldering portion soldered with the above-described solder paste.

### EFFECT OF THE INVENTION

In the solder alloy according to one aspect of the present invention, the solder alloy consisting of tin, silver, copper, bismuth, antimony, and cobalt is designed to contain the components in the above-described amounts.

Therefore, the solder alloy according to one aspect of the present invention achieves excellent shock resistance, and can keep excellent shock resistance even under exposure to relatively severe temperature cycle conditions.

The solder paste according to another aspect of the present invention contains the above-described solder alloy, and therefore achieves excellent shock resistance, and can keep excellent shock resistance even under exposure to relatively severe temperature cycle conditions.

In the electronic circuit board according to still another aspect of the present invention, the above-described solder paste are used in soldering, and therefore excellent shock resistance can be achieved, and excellent shock resistance can be kept even under exposure to relatively severe temperature cycle conditions.

### DESCRIPTION OF EMBODIMENTS

The solder alloy according to one aspect of the present invention contains, as essential components, tin (Sn), silver (Ag), copper (Cu), bismuth (Bi), antimony (Sb), and cobalt (Co). In other words, the solder alloy consists essentially of tin, silver, copper, bismuth, antimony, and cobalt. In this specification, "essentially" means that allowing the above-described elements to be essential components and an optional component to be described later to be contained at a proportion to be described later.

In the solder alloy, the tin content is the remaining ratio relative to each of the components to be described later and is suitably set in accordance with the amount of the components blended.

The silver content relative to a total amount of the solder alloy is 2 mass% or more, preferably 3.0 mass% or more, more preferably 3.3 mass% or more, 4 mass% or less, preferably 3.8 mass% or less, more preferably 3.6 mass% or less.

When the silver content is within the above-described range, excellent shock resistance can be achieved, and excellent shock resistance can be kept even under exposure to relatively severe temperature cycle conditions.

Meanwhile, when the silver content is below the above-described lower limit, shock resistance is poor. When the silver content is more than the above-described upper limit as well, shock resistance is poor.

The copper content relative to a total amount of the solder alloy is 0.3 mass% or more, preferably 0.5 mass% or more, and 1 mass% or less, preferably 0.7 mass% or less.

When the copper content is within the above-described range, excellent shock resistance can be achieved, and excellent shock resistance can be kept even under exposure to relatively severe temperature cycle conditions.

Meanwhile, when the copper content is below the above-described lower limit, shock resistance is poor. When the copper content is more than the above-described upper limit as well, shock resistance is poor.

The bismuth content relative to a total amount of the solder alloy is more than 4.8 mass%, 10 mass% or less, preferably 7 mass% or less.

When the bismuth content is within the above-described range, excellent shock resistance can be achieved, and excellent shock resistance can be kept even under exposure to relatively severe temperature cycle conditions.

Meanwhile, when the bismuth content is below the above-described lower limit, shock resistance is poor. When the bismuth content is more than the above-described upper limit as well, shock resistance is poor.

The antimony content relative to a total amount of the solder alloy is 3 mass% or more, preferably more than 3 mass%, more preferably 5 mass% or more, and 10 mass% or less, preferably 9.2 mass% or less, more preferably 7 mass% or less.

When the antimony content is within the above-described range, excellent shock resistance can be achieved, and excellent shock resistance can be kept even under exposure to relatively severe temperature cycle conditions.

Meanwhile, when the antimony content is below the above-described lower limit, shock resistance is poor. When the antimony content is more than the above-described upper limit as well, shock resistance is poor.

The cobalt content relative to a total amount of the solder alloy is 0.001 mass% or more, preferably 0.003 mass% or more, and 0.3 mass% or less, preferably 0.01 mass% or less, more preferably 0.007 mass% or less.

When the cobalt content is within the above-described range, excellent shock resistance can be achieved, and excellent shock resistance can be kept even under exposure to relatively severe temperature cycle conditions.

Meanwhile, when the cobalt content is below the above-described lower limit, shock resistance is poor. When the cobalt content is more than the above-described upper limit as well, shock resistance is poor.

The above-described solder alloy may optionally contain at least one element selected from the group consisting of nickel (Ni), indium (In), gallium (Ga), germanium (Ge), and phosphorus (P).

When the nickel is contained as an optional component, the nickel content is, for example, 1.0 mass% or less, relative to the total amount of the solder alloy.

When the nickel content is within the above-described range, excellent effects of the present invention can be retained.

When the indium is contained as an optional component, the indium content relative to a total amount of the solder alloy is, for example, 1.0 mass% or less.

When the indium content is within the above-described range, excellent effects of the present invention can be retained.

When the gallium is contained as an optional component, the gallium content relative to the total amount of the solder alloy is, for example, 1.0 mass% or less.

When the gallium content is within the above-described range, excellent effects of the present invention can be retained.

When the germanium is contained as an optional component, the germanium content relative to the total amount of the solder alloy is, for example, 1.0 mass% or less.

When the germanium content is within the above-described range, excellent effects of the present invention can be retained.

When the phosphorus is contained as an optional component, the phosphorus content relative to the total amount of the solder alloy is, for example, 1.0 mass% or less.

When the phosphorus content is within the above-described range, excellent effects of the present invention can be retained.

These optional components can be used singly or in combination of two or more.

When the above-described element is contained as an optional component, the content ratio thereof (in the case of being used in combination of two or more, the total amount thereof) relative to the total amount of the solder alloy is adjusted to be, for example, 1.0 mass% or less.

When the total amount of the optional component content is within the above-described range, excellent effects of the present invention can be retained.

In view of improvement in shock resistance, in the above-described solder alloy, preferably, iron (Fe) is intentionally not contained. In other words, the solder alloy preferably contains no iron (Fe) except for iron (Fe) as impurity to be described later.

Such a solder alloy can be obtained by alloying the above-described metal components by a known method such as melting the metal components in a melting furnace to be unified.

The above-described metal components used in the production of the solder alloy can contain a small amount of impurities (inevitable impurities) as long as the excellent effects of the present invention are not inhibited.

Examples of the impurities include aluminum (Al), iron (Fe), zinc (Zn), and gold (Au).

The melting point of the solder alloy obtained in this manner measured by a DSC method (measurement conditions: temperature rising rate of 0.5°C/min.) is, for example, 190°C or more, or preferably 200°C or more, and, for example, 250°C or less, or preferably 240°C or less.

When the melting point of the solder alloy is within the above-described range, in a case where the solder alloy is used in the solder paste, metal connection can be easily performed with excellent workability.

In the above-described solder alloy, the solder alloy consisting essentially of tin, silver, copper, bismuth, antimony, and cobalt is designed to contain the components in the above-described predetermined amounts.

Therefore, the above-described solder alloy achieves excellent shock resistance, and excellent shock resistance can be kept even under exposure to relatively severe temperature cycle conditions.

Thus, the solder alloy is preferably contained in the solder paste (solder paste connecting material).

To be specific, the solder paste according to another aspect of the present invention contains the above-described solder alloy and flux.

The solder alloy in a powdered shape is preferably contained in the solder paste.

The powdered shape is not particularly limited and examples thereof include a substantially complete sphere shape, a flat block shape, a needle shape, and an amorphous shape. The powdered shape is suitably set in accordance with the properties (e.g., thixotropy, viscosity, etc.) required for the solder paste.

The average particle size (in the case of sphere shape) or the average longitudinal length (in the case of not sphere shape) of the powder of the solder alloy is, for example, 5 µm or more, or preferably 15 µm or more and, for example, 100 µm or less, or preferably 50 µm or less in measurement by using a particle diameter and particle size distribution analyzer by a laser diffraction method.

The flux is not particularly limited and known solder flux can be used.

To be specific, the flux is mainly composed of, for example, a base resin (rosin, acrylic resin, or the like), an activator (for example, hydrohalogenic acid salt of amine such as ethylamine and propylamine, and organic carboxylic acids such as lactic acid, citric acid, and benzoic acid), and a thixotropic agent (hardened castor oil, bees wax, carnauba wax, or the like) and can further contain an organic solvent when liquid flux is used.

The solder paste can be obtained by mixing the powder made from the above-described solder alloy with the above-described flux by a known method.

The mixing ratio of the solder alloy to the flux (solder alloy: flux (mass ratio)), is, for example, 70: 30 to 95: 5.

The above-described solder paste contains the above-described solder alloy, and therefore excellent shock resistance can be achieved, and excellent shock resistance can be kept even under exposure to relatively severe temperature cycle conditions.

The present invention includes an electronic circuit board including a soldering portion soldered with the above-described solder paste.

That is, the above-described solder paste is preferably used in, for example, soldering (metal connection) of an electrode of an electronic circuit board of, for example, an electrical and electronic device with an electronic component.

The electronic component is not particularly limited and an example thereof includes a known electronic component such as chip components (IC chip or the like), resistors, diodes, condensers, and transistors.

In the electronic circuit board, the above-described solder paste is used in soldering, and therefore excellent shock resistance can be achieved, and excellent shock resistance can be kept even under exposure to relatively severe temperature cycle conditions.

The method for using the above-described solder alloy is not limited to the above-described solder paste, and for example, the above-described solder alloy can be also used in, for example, the production of a resin flux cored solder connecting material. To be specific, for example, the above-described solder alloy is formed into a linear shape with the above-described flux as a core by a known method (for example, extrusion molding or the like), so that the resin flux cored solder connecting material can be also obtained.

Such a resin flux cored solder connecting material is also preferably used in, for example, soldering (metal connection) of an electronic circuit board of, for example, an electrical and electronic device in the same manner as that of the solder paste.

### Examples

The present invention will hereinafter be described based on Examples and Comparative Examples. The present invention is however not limited by the following Examples. The specific numerical values in mixing ratio (content), property value, and parameter used in the following description can be replaced with upper limits (numerical values defined with "or less" or "below") or lower limits (numerical values defined with "or more" or "more than") of corresponding numerical values in mixing ratio (content), property value, and parameter described in the above-described "DESCRIPTION OF EMBODIMENTS".

### Examples 1 to 24 and Comparative Examples 1 to 16

### Preparation of Solder Alloy

The powder of each of the metals described in Tables 1 to 2 was mixed at the mixing ratio described in Tables 1 to 2 and each of the obtained metal mixtures was melted to be unified in a melting furnace, thereby preparing solder alloys.

The tin (Sn) content in the mixing formulation of Examples and Comparative Examples is the remaining portion deducting the metals (silver (Ag), copper (Cu), bismuth (Bi), antimony (Sb), cobalt (Co), nickel (Ni), indium (In), gallium (Ga), germanium (Ge), phosphorus (P) and iron (Fe))(mass%) shown in Tables 1 to 2 from the total amount of the solder alloy.

In the solder alloy of Example 1, metals of Ag, Cu, Bi, Sb, and Co are blended at the ratio shown in Table 1. The remaining portion is Sn.

In Examples 2 to 4, the Ag content was increased/decreased relative to the formulation in Example 1.

In Examples 5 to 7, the Cu content was increased/decreased relative to the formulation in Example 1.

In Examples 8 to 10, the Bi content was increased/decreased relative to the formulation in Example 1.

In Examples 11 to 14, the Sb content was increased/decreased relative to the formulation in Example 1.

In Examples 15 to 18, the Co content was increased/decreased relative to the formulation in Example 1.

In Examples 19 to 23, one of Ni, In, Ga, Ge, and P was added at the ratio shown in Table 1 relative to the formulation in Example 1, and in Example 24, all of Ni, In, Ga, Ge, and P was added at the ratio shown in Table 1 relative to the formulation in Example 1.

In Comparative Examples 1 to 2, the amount of Ag blended was increased/decreased relative to the formulation in Example 1 to make Ag excessive or insufficient.

In Comparative Examples 3 to 4, the amount of Cu blended was increased/decreased relative to the formulation in Example 1 to make Cu excessive or insufficient.

In Comparative Examples 5 to 6, the amount of Bi blended was increased/decreased relative to the formulation in Example 1 to make Bi excessive or insufficient.

In Comparative Examples 7 to 8, the amount of Sb blended was increased/decreased relative to the formulation in Example 1 to make Sb excessive or insufficient.

In Comparative Examples 9 to 10, the amount of Co blended was increased/decreased relative to the formulation in Example 1 to make Co excessive or insufficient.

In Comparative Example 11, the amounts of Bi and Sb blended were decreased to make both of Bi and Sb insufficient relative to the formulation in Example 17, and Ni was blended in the amount shown in Table 1.

In Comparative Example 12, the amounts of Bi and Sb blended were decreased to make both of Bi and Sb insufficient relative to the formulation in Example 17.

In Comparative Example 13, relative to the formulation in Example 17, Fe (0.01 mass%) was blended instead of Co (0.01 mass%).

In Comparative Example 14, the amount of Bi blended was decreased to make Bi insufficient relative to the formulation in Example 17.

In Comparative Example 15, the amount of Sb blended was decreased to make Sb insufficient relative to the formulation in Example 17.

In Comparative Example 16, Fe was further blended relative to the formulation in Examples 17.

### Preparation of Solder Paste

The obtained solder alloy was powdered so that the particle size thereof was 25 to 38 µm. The obtained powder of the solder alloy was mixed with known flux, thereby producing a solder paste.

### Evaluation of Solder Paste

The obtained solder paste was printed on a print board for mounting chip components and a chip component was mounted thereon by a reflow method. The printing conditions of the solder paste at the time of mounting, the size of the chip component, and the like were suitably set in accordance with each of the evaluations to be described later.

**[Table 1]**

| No. | Mixing formulation (mass%) | | | | | | | | | | |
|---|---|---|---|---|---|---|---|---|---|---|---|
| | Ag | Cu | Bi | Sb | Co | Ni | In | Ga | Ge | P | Fe |
| Example 1 | 3.5 | 0.7 | 5.0 | 5.0 | 0.005 | - | - | - | - | - | - |
| Example 2 | 2.0 | 0.7 | 5.0 | 5.0 | 0.005 | - | - | - | - | - | - |
| Example 3 | 3.0 | 0.7 | 5.0 | 5.0 | 0.005 | - | - | - | - | - | - |
| Example 4 | 4.0 | 0.7 | 5.0 | 5.0 | 0.005 | - | - | - | - | - | - |
| Example 5 | 3.5 | 0.3 | 5.0 | 5.0 | 0.005 | - | - | - | - | - | - |
| Example 6 | 3.5 | 0.5 | 5.0 | 5.0 | 0.005 | - | - | - | - | - | - |
| Example 7 | 3.5 | 1.0 | 5.0 | 5.0 | 0.005 | - | - | - | - | - | - |
| Example 8 | 3.5 | 0.7 | 4.9 | 5.0 | 0.005 | - | - | - | - | - | - |
| Example 9 | 3.5 | 0.7 | 7.0 | 5.0 | 0.005 | - | - | - | - | - | - |
| Example 10 | 3.5 | 0.7 | 10.0 | 5.0 | 0.005 | - | - | - | - | - | - |
| Example 11 | 3.5 | 0.7 | 5.0 | 3.0 | 0.005 | - | - | - | - | - | - |
| Example 12 | 3.5 | 0.7 | 5.0 | 7.0 | 0.005 | - | - | - | - | - | - |
| Example 13 | 3.5 | 0.7 | 5.0 | 8.5 | 0.005 | - | - | - | - | - | - |
| Example 14 | 3.5 | 0.7 | 5.0 | 10.0 | 0.005 | - | - | - | - | - | - |
| Example 15 | 3.5 | 0.7 | 5.0 | 5.0 | 0.001 | - | - | - | - | - | - |
| Example 16 | 3.5 | 0.7 | 5.0 | 5.0 | 0.003 | - | - | - | - | - | - |
| Example 17 | 3.5 | 0.7 | 5.0 | 5.0 | 0.010 | - | - | - | - | - | - |
| Example 18 | 3.5 | 0.7 | 5.0 | 5.0 | 0.300 | - | - | - | - | - | - |
| Example 19 | 3.5 | 0.7 | 5.0 | 5.0 | 0.005 | 0.5 | - | - | - | - | - |
| Example 20 | 3.5 | 0.7 | 5.0 | 5.0 | 0.005 | - | 0.5 | - | - | - | - |
| Example 21 | 3.5 | 0.7 | 5.0 | 5.0 | 0.005 | - | - | 0.5 | - | - | - |
| Example 22 | 3.5 | 0.7 | 5.0 | 5.0 | 0.005 | - | - | - | 0.5 | - | - |
| Example 23 | 3.5 | 0.7 | 5.0 | 5.0 | 0.005 | - | - | - | - | 0.5 | - |
| Example 24 | 3.5 | 0.7 | 5.0 | 5.0 | 0.005 | 0.1 | 0.1 | 0.1 | 0.1 | 0.1 | - |

**[Table 2]**

| No. | Mixing formulation (mass%) | | | | | | | | | | |
|---|---|---|---|---|---|---|---|---|---|---|---|
| | Ag | Cu | Bi | Sb | Co | Ni | In | Ga | Ge | P | Fe |
| Comp. Ex. 1 | 1.5 | 0.7 | 5.0 | 5.0 | 0.005 | - | - | - | - | - | - |
| Comp. Ex. 2 | 4.5 | 0.7 | 5.0 | 5.0 | 0.005 | - | - | - | - | - | - |
| Comp. Ex. 3 | 3.5 | 0.1 | 5.0 | 5.0 | 0.005 | - | - | - | - | - | - |
| Comp. Ex. 4 | 3.5 | 1.5 | 5.0 | 5.0 | 0.005 | - | - | - | - | - | - |
| Comp. Ex. 5 | 3.5 | 0.7 | 4.5 | 5.0 | 0.005 | - | - | - | - | - | - |
| Comp. Ex. 6 | 3.5 | 0.7 | 10.5 | 5.0 | 0.005 | - | - | - | - | - | - |
| Comp. Ex. 7 | 3.5 | 0.7 | 5.0 | 2.5 | 0.005 | - | - | - | - | - | - |
| Comp. Ex. 8 | 3.5 | 0.7 | 5.0 | 10.5 | 0.005 | - | - | - | - | - | - |
| Comp. Ex. 9 | 3.5 | 0.7 | 5.0 | 5.0 | 0.000 | - | - | - | - | - | - |
| Comp. Ex. 10 | 3.5 | 0.7 | 5.0 | 5.0 | 0.400 | - | - | - | - | - | - |
| Comp. Ex. 11 | 3.5 | 0.7 | 3.2 | 3.0 | 0.01 | 0.04 | - | - | - | - | - |
| Comp. Ex. 12 | 3.5 | 0.7 | 3.2 | 3.0 | 0.01 | - | - | - | - | - | - |
| Comp. Ex. 13 | 3.5 | 0.7 | 5.0 | 5.0 | - | - | - | - | - | - | 0.01 |
| Comp. Ex. 14 | 3.5 | 0.7 | 3.2 | 5.0 | 0.01 | - | - | - | - | - | - |
| Comp. Ex. 15 | 3.5 | 0.7 | 5.0 | 2.8 | 0.01 | - | - | - | - | - | - |
| Comp. Ex. 16 | 3.5 | 0.7 | 5.0 | 5.0 | 0.01 | - | - | - | - | - | 0.01 |

### <Evaluation>

The solder paste using the alloy produced in Examples and Comparative Example was printed on a printed board for mounting chip components, and a chip component was mounted thereon by a reflow method. The thickness of the printed solder paste was adjusted using a metal mask having a thickness of 150 µm. After printing of the solder paste, an aluminum electrolytic capacitor (5 mmϕ, height 5.8 mm) was mounted on a predetermined position on the above-described printed circuit board, and they were heated in a reflow oven, thereby mounting the chip component. The reflow conditions were set as follows: preheating of 170 to 190°C, peak temperature of 245°C, time for the oven being at 220°C or more to be 45 seconds, and cooling rate at the time when the temperature decreased from the peak temperature to 200°C to be 3 to 8°C/sec.

Furthermore, the above-described printed circuit board was subjected to a cooling/heating cycle test in which it was kept under the environment of 125°C for 30 minutes, and then, kept under the environment of -40°C for 30 minutes. The results are shown in Table 3 and Table 4.

### <Drop/shock>

The printed circuit board immediately after mounting the components was dropped from a height of 1m for 5 times, and evaluation was conducted by observing its appearance: it was checked if the connection portion between the component and the board was broken or not.

To be specific, of the 100 components mounted, those with dropped components of 5 or less were evaluated as rank A++ (5 points), those with dropped components of 6 to 10 were evaluated as rank A+ (4 points), those with dropped components of 11 to 15 were evaluated as rank A (3 points), those with dropped components of 16 to 30 were evaluated as rank B (2 points), those with dropped components of 31 to 50 were evaluated as rank C (1 point), and those with dropped components of 51 or more was evaluated as rank D (0 point).

Those printed circuit boards that went through the repeated cooling/heating cycles of 1000 cycles were evaluated in the same manner as described above.

### <Comprehensive Evaluation>

In "Drop/shock" and "Shock resistance after cooling/heating cycle", those with a total point of 10 was evaluated comprehensively as A++, a total point of 8 or 9 were evaluated comprehensively as A+, a total point of 6 or 7 points were evaluated comprehensively as A, a total point of 4 or 5 points were evaluated comprehensively as B, a total point of 2 or 3 points were evaluated comprehensively as C, and a total point of 0 or 1 point were evaluated comprehensively as D.

**[Table 3]**

| No. | Shock resistance | Shock resistance after cooling/heating cycle | Comprehensive Evaluation |
|---|---|---|---|
| Example 1 | A++ | A++ | A++ |
| Example 2 | A+ | A | A |
| Example 3 | A++ | A+ | A+ |
| Example 4 | A+ | A | A |
| Example 5 | A | A | A |
| Example 6 | A+ | A+ | A+ |
| Example 7 | A | A | A |
| Example 8 | A++ | A+ | A+ |
| Example 9 | A+ | A | A |
| Example 10 | A | B | B |
| Example 11 | A | B | B |
| Example 12 | A+ | A+ | A+ |
| Example 13 | A | A | A |
| Example 14 | B | B | B |
| Example 15 | A | A | A |
| Example 16 | A++ | A+ | A+ |
| Example 17 | A+ | A+ | A+ |
| Example 18 | A | B | B |
| Example 19 | A++ | A++ | A++ |
| Example 20 | A++ | A++ | A++ |
| Example 21 | A++ | A++ | A++ |
| Example 22 | A++ | A++ | A++ |
| Example 23 | A++ | A++ | A++ |
| Example 24 | A++ | A++ | A++ |

**[Table 4]**

| No. | Shock resistance | Shock resistance after cooling/heating cycle | Comprehensive Evaluation |
|---|---|---|---|
| Comp. Ex. 1 | B | C | C |
| Comp. Ex. 2 | B | C | C |
| Comp. Ex. 3 | B | C | C |
| Comp. Ex. 4 | B | C | C |
| Comp. Ex. 5 | D | D | D |
| Comp. Ex. 6 | D | D | D |
| Comp. Ex. 7 | D | D | D |
| Comp. Ex. 8 | D | D | D |
| Comp. Ex. 9 | D | D | D |
| Comp. Ex. 10 | D | D | D |
| Comp. Ex. 11 | D | D | D |
| Comp. Ex. 12 | D | D | D |
| Comp. Ex. 13 | D | D | D |
| Comp. Ex. 14 | C | D | D |
| Comp. Ex. 15 | C | D | D |
| Comp. Ex. 16 | C | C | C |

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The solder alloy, the solder composition, and the solder paste of the present invention are used in an electronic circuit board used for electrical and electronic devices or the like.

## Claims

1. A solder alloy consisting of tin, silver, copper, bismuth, antimony, and cobalt,
wherein relative to a total amount of the solder alloy,
the silver content is 2 mass% or more and 4 mass% or less,
the copper content is 0.3 mass% or more and 1 mass% or less,
the bismuth content is more than 4.8 mass% and 10 mass% or less,
the antimony content is 3 mass% or more and 10 mass% or less,
the cobalt content is 0.001 mass% or more and 0.3 mass% or less, and
optionally at least one element selected from the group consisting of nickel, indium, gallium, germanium, and phosphorus, wherein relative to a total amount of the solder alloy, 1 mass% or less of the at least one optional element is contained;
the balance, except for inevitable impurities, is the tin content of the solder alloy.

2. The solder alloy according to Claim 1, wherein the copper content is 0.5 mass% or more and 0.7 mass% or less.

3. The solder alloy according to Claim 1, wherein the bismuth content is more than 4.8 mass% and 7 mass% or less.

4. The solder alloy according to Claim 1, wherein the antimony content is 5 mass% or more and 7 mass% or less.

5. The solder alloy according to Claim 1, wherein the cobalt content is 0.003 mass% or more and 0.01 mass% or less.

6. A solder paste comprising a solder powder composed of the solder alloy according to Claim 1, and flux.

7. An electronic circuit board comprising a soldering portion soldered with the solder paste of Claim 6.

## Patentansprüche

1. Lötmittellegierung, bestehend aus Zinn, Silber, Kupfer, Wismut, Antimon und Kobalt,
wobei bezogen auf die Gesamtmenge der Lötmittellegierung
der Silbergehalt 2 Gew.-% oder mehr und 4 Gew.-% oder weniger beträgt,
der Kupfergehalt 0,3 Gew.-% oder mehr und 1 Gew.-% oder weniger beträgt,
der Wismutgehalt mehr als 4,8 Gew.-% und 10 Gew.-% oder weniger beträgt,
der Antimongehalt 3 Gew.-% oder mehr und 10 Gew.-% oder weniger beträgt,
der Kobaltgehalt 0,001 Gew.-% oder mehr und 0,3 Gew.-% oder weniger beträgt, und
wahlweise mindestens einem Element, das aus der Gruppe ausgewählt ist, die aus Nickel, Indium, Gallium, Germanium und Phosphor besteht, wobei bezogen auf die Gesamtmenge der Lötmittellegierung 1 Gew.-% oder weniger des mindestens einen wahlweisen Elements enthalten ist;
wobei der Rest mit Ausnahme von unvermeidbaren Verunreinigungen der Zinngehalt der Lötmittellegierung ist.

2. Lötmittellegierung nach Anspruch 1, wobei der Kupfergehalt 0,5 Gew.-% oder mehr und 0,7 Gew.-% oder weniger beträgt.

3. Lötmittellegierung nach Anspruch 1, wobei der Wismutgehalt mehr als 4,8 Gew.-% und 7 Gew.-% oder weniger beträgt.

4. Lötmittellegierung nach Anspruch 1, wobei der Antimongehalt 5 Gew.-% oder mehr und 7 Gew.-% oder weniger beträgt.

5. Lötmittellegierung nach Anspruch 1, wobei der Kobaltgehalt 0,003 Gew.-% oder mehr und 0,01 Gew.-% oder weniger beträgt.

6. Lötmittelpaste, die ein Lötmittelpulver, das aus der Lötmittellegierung nach Anspruch 1 und einem Flussmittel zusammengesetzt ist, umfasst.

7. Elektronische Leiterplatte, die einen Lötabschnitt, der mit der Lötmittelpaste nach Anspruch 6 gelötet ist, umfasst.

## Revendications

1. Alliage de soudage constitué d'étain, d'argent, de cuivre, de bismuth, d'antimoine et de cobalt,
dans lequel, par rapport à une quantité totale de l'alliage de soudage,
la teneur en argent est égale ou supérieure à 2% en masse ou plus et égale ou inférieure à 4% en masse,
la teneur en cuivre est égale ou supérieure à 0,3% en masse et égale ou inférieure à 1% en masse,
la teneur en bismuth est supérieure à 4,8% en masse et égale ou inférieure à 10% en masse,
la teneur en antimoine est égale ou supérieure à 3% en masse et égale ou inférieure à 10% en masse,
la teneur en cobalt est égale ou supérieure à 0,001% en masse et égale ou inférieure à 0,3% en masse, et
éventuellement au moins un élément sélectionné dans le groupe constitué du nickel, de l'indium, du gallium, du germanium et du phosphore, dans lequel, par rapport à une quantité totale de l'alliage de soudage, 1% en masse ou moins de l'au moins un élément facultatif est contenu ;
le reste, sauf impuretés inévitables, correspond à la teneur en étain de l'alliage de soudage.

2. Alliage de soudage selon la revendication 1, dans lequel la teneur en cuivre est égale ou supérieure à 0,5% en masse et égale ou inférieure à 0,7% en masse.

3. Alliage de soudage selon la revendication 1, dans lequel la teneur en bismuth est supérieure à 4,8% en masse et égale ou inférieure à 7% en masse.

4. Alliage de soudage selon la revendication 1, dans lequel la teneur en antimoine est égale ou supérieure à 5% en masse et égale ou inférieure à 7% en masse.

5. Alliage de soudage selon la revendication 1, dans lequel la teneur en cobalt est égale ou supérieure à 0,003% en masse et égale ou inférieure à 0,01% en masse.

6. Pâte de soudage comprenant une poudre de soudage composée de l'alliage de soudage selon la revendication 1 et d'un flux.

7. Carte de circuit électronique comprenant une partie de soudage soudée avec la pâte de soudage selon la revendication 6.
